# EUROPEAN PATENT APPLICATION

(11) **EP 4 848 291 A1**
(43) Date of publication of application: **02.12.2026**
(21) Application number: 26181332.3
(22) Date of filing: 27.05.2026
(51) Int. Cl.: G11C 29/32, G01R 31/3185, G11C 15/04

(54) **SCAN TEST CIRCUIT FOR TESTING FLIP-FLOPS THAT ARE USED TO BUFFER MATCH LINE OUTPUTS OF CONTENT ADDRESSABLE MEMORY**

(30) Priority: 29.05.2025 US 202563813825 P; 26.05.2026 US 202619688480
(71) Applicant: MediaTek Inc., Hsinchu City 30078 (TW)
(72) Inventor: KUMAR, Sushil, San Jose, 95134 (US); JEDHE, Gajanan Sahebrao, San Jose, 95134 (US); GOGOI, Agastya, San Jose, 95134 (US); DESHPANDE, Chetan, San Jose, 95134 (US); GARG, Ritesh, San Jose, 95134 (US)
(74) Representative: Hoefer & Partner Patentanwälte mbB

(57) **Abstract**

A scan test circuit (200) includes a scan chain (202). The scan chain (202) includes a plurality of scan flip-flops (204_0, 204_j), each having a data input node, a scan input node, and an output node, wherein the data input node is configured to receive a functional data input from a match line of a content addressable memory. For example, the content addressable memory is a ternary content addressable memory.

## Description

### Field of the Invention

The present invention relates to a scan test design, and more particularly, to a scan test circuit for testing flip-flops that are used to buffer match line outputs of a content addressable memory (CAM).

### Background of the Invention

Design for Testability (DFT) is a vital methodology in the semiconductor and electronics industries focused on improving the testability of integrated circuits (ICs) and systems-on-chip (SoCs). At its core, DFT involves incorporating specific features and structures within hardware designs to enable efficient and effective testing after manufacturing. These design choices ensure that defects introduced during fabrication can be detected quickly and cost-effectively, thereby increasing product quality and reliability. In other words, DFT improves controllability and observability, which helps in improving the circuit testability. Regarding a CAM design such as a ternary content addressable memory (TCAM) design, it has flip-flops used to buffer match line outputs (i.e., HIT outputs), where Hit=1 indicates that match is found, and Hit=0 indicates that no match is found. Without the scannable HIT flip-flops, it is easy to miss the defects on match lines.

### Summary of the Invention

This in mind, the present invention aims at providing a scan test circuit for testing flip-flops that are used to buffer match line outputs of a CAM.

This is achieved by scan test circuit(s) according to independent claim(s). The dependent claims pertain to corresponding further developments and improvements. The invention is set out in the appended set of claims.

As will be seen more clearly from the detailed description following below, the claimed scan test circuit includes a scan chain. The scan chain includes a plurality of scan flip-flops, each having a data input node, a scan input node, and an output node, wherein the data input node is configured to receive a functional data input from a match line of a CAM.

Another claimed scan test circuit includes a scan chain and a first multiplexer. The scan chain includes a plurality of scan flip-flops, each having a data input node, a scan input node, and an output node, wherein the plurality of scan flip-flops comprise a first scan flip-flop and a second scan flip-flop, and the scan chain starts from the first scan flip-flop and ends at the second scan flip-flop. The first multiplexer has a first input node, a second input node, and an output node, wherein the first input node of the first multiplexer is configured to receive a scan chain data input of the scan chain, the second input node of the first multiplexer is configured to receive a scan data output from the output node of the second scan flip-flop, and the output node of the first multiplexer is configured to output one of the scan chain data input and the scan data output to the scan input node of the first scan flip-flop.

### Brief Description of the Drawings

In the following, the invention is further illustrated by way of example, taking reference to the accompanying drawings. Thereof
FIG. 1 is a diagram illustrating a CAM with scan flip-flops for HIT outputs according to an embodiment of the present invention,
FIG. 2 is a diagram illustrating a scan test circuit according to an embodiment of the present invention,
FIG. 3 is a diagram illustrating multiple scan test circuits employed by the CAM shown in FIG. 1 according to an embodiment of the present invention,
FIG. 4 is a diagram illustrating the scan test circuit shown in FIG. 2 that operates in a Scan Shift mode according to an embodiment of the present invention, and
FIG. 5 is a diagram illustrating the scan test circuit shown in FIG. 2 that operates in a Scan Capture mode according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

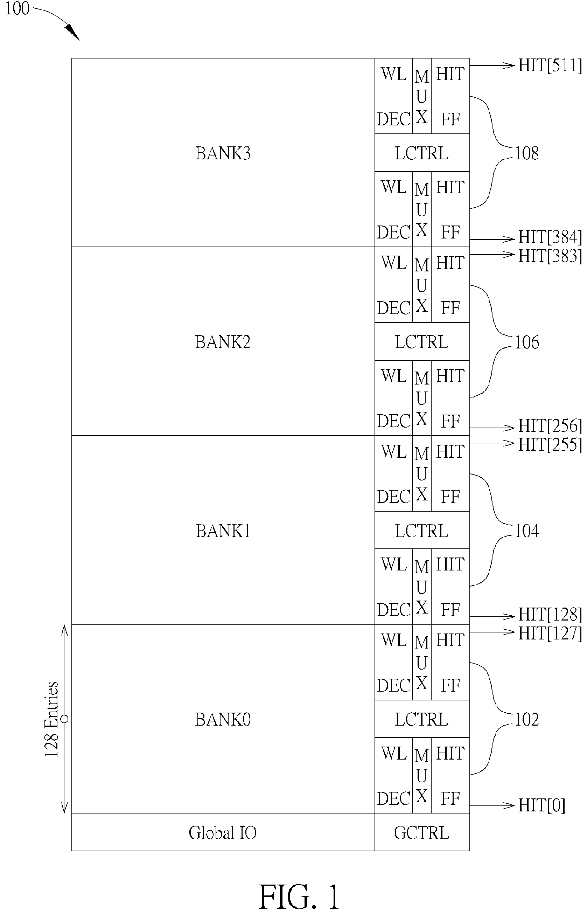

FIG. 1 is a diagram illustrating a CAM with scan flip-flops for HIT outputs according to an embodiment of the present invention. By way of example, but not limitation, the CAM 100 may be a TCAM with multiple banks BANK0, BANK1, BANK2, BANK3. Regarding the bank BANK0, HIT outputs HIT[0]-HIT[127] generated on different match lines are buffered in HIT flip-flops (denoted by "HIT FF") 102, respectively. Regarding the bank BANK1, HIT outputs HIT[128]-HIT[255] generated on different match lines are buffered in HIT flip-flops (denoted by "HIT FF") 104, respectively. Regarding the bank BANK2, HIT outputs HIT[256]-HIT[383] generated on different match lines are buffered in HIT flip-flops (denoted by "HIT FF") 106, respectively. Regarding the bank BANK3, HIT outputs HIT[384]-HIT[511] generated on different match lines are buffered in HIT flip-flops (denoted by "HIT FF") 108, respectively. In this embodiment, DFT insertion (particularly, scan insertion) is implemented for TCAM match lines. Hence, each of the HIT flip-flops 102, 104, 106, 108 is implemented using a scan flip-flop to enable a scan test. In this embodiment, one match-line scan chain is formed for each bank to reduce the time to load and observe. For example, match lines of the CAM (e.g., TCAM) 100 may be divided into four match line groups for different banks BANK0-BANK3. Hence, a scan test circuit for testing HIT flip-flops 102 of the bank BANK0 has a scan chain formed by chaining 128 (i.e., j+1=128) scan flip-flops included in only one of the match line groups, a scan test circuit for testing HIT flip-flops 104 of the bank BANK1 has a scan chain formed by chaining 128 (i.e., j+1=128) scan flip-flops included in only one of the match line groups, a scan test circuit for testing HIT flip-flops 106 of the bank BANK2 has a scan chain formed by chaining 128 (i.e., j+1=128) scan flip-flops included in only one of the match line groups, and a scan test circuit for testing HIT flip-flops 108 of the bank BANK3 has a scan chain formed by chaining 128 (i.e., j+1=128) scan flip-flops included in only one of the match line groups. The number of HIT outputs HIT[0]-HIT[511] generated from the CAM (e.g., TCAM) 100 is 512. In this embodiment, the maximum scan length is limited to 128, which helps reducing scan shift and testing time.

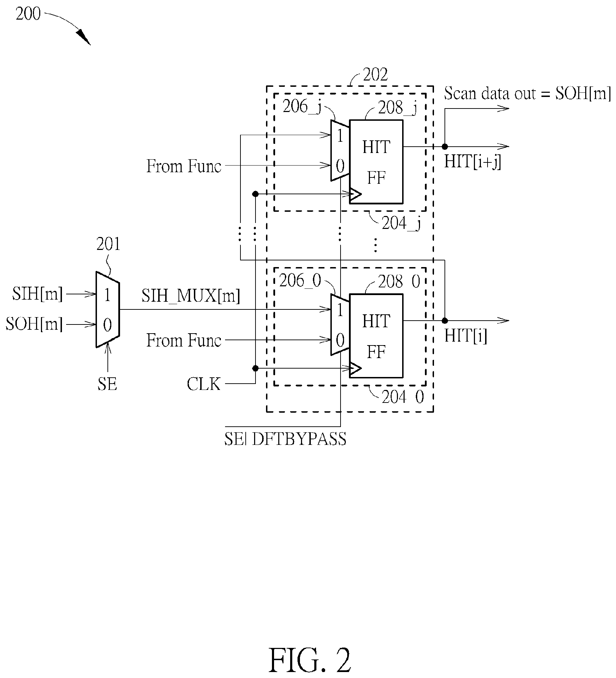

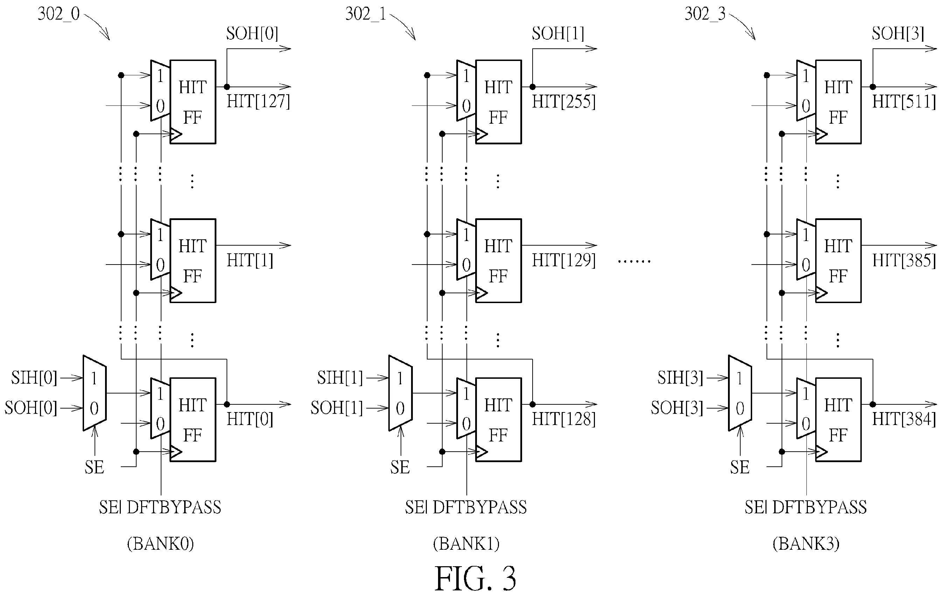

FIG. 2 is a diagram illustrating a scan test circuit according to an embodiment of the present invention. Each of the scan test circuits employed by the CAM (e.g., TCAM) 100 for testing HIT flip-flops may be implemented using the scan test circuit 200. FIG. 3 is a diagram illustrating multiple scan test circuits employed by the CAM (e.g., TCAM) 100 according to an embodiment of the present invention. As shown in FIG. 3, the scan test circuit 302_0 is used for testing HIT flip-flops 102 of the bank BANK0, the scan test circuit 302_1 is used for testing HIT flip-flops 104 of the bank BANK1, and the scan test circuit 302_3 is used for testing HIT flip-flops 108 of the bank BANK3. Implementation of the scan test circuits 302_0-302_3 is based on the same circuit structure shown in FIG. 2. Further details of the scan test circuit 200 are described as below with reference to the accompanying drawings.

As shown in FIG. 2, the scan test circuit 200 includes a multiplexer 201 and a scan chain 202. The scan chain 202 includes a plurality of scan flip-flops (also called scan cells) 204_0-204_j (j ≥ 1), each having a multiplexer and a HIT flip-flop (denoted by "HIT FF"). Regarding the scan flip-flop 204_0, the multiplexer 206_0 has a first input node (denoted by "1"), a second input node (denoted by "0") and an output node, and the HIT flip-flop 208_0 has a data input node, a clock input node and a data output node, where the first input node of the multiplexer 206_0 acts as a scan input node of the scan flip-flop 204_0, the second input node of the multiplexer 206_0 acts as a data input node of the scan flip-flop 204_0, the output node of the multiplexer 206_0 is coupled to the data input node of the HIT flip-flop 208_0, and the data output node of the HIT flip-flop 208_0 acts as a scan/data output node of the scan flip-flop 204_0. The multiplexer 206_0 is controlled by control signals SE and DFTBYPASS. For example, a control input of the multiplexer 206_0 is set by ORing SE and DFTBYPASS. The data input node of the scan flip-flop 204_0 is configured to receive a functional data input from a functional path Func. In this embodiment, the data input node of the scan flip-flop 204_0 is configured to receive a functional data input (e.g., an HIT output HIT[i]) from a match line of the CAM (e.g., TCAM) 100. During a normal operation, the HIT flip-flop 208_0 is used to buffer the HIT output HIT[i] and output the buffered HIT output HIT[i] to a following processing circuit such as a priority encoder (not shown).

Similarly, regarding the scan flip-flop 204_j, the multiplexer 206_j has a first input node (denoted by "1"), a second input node (denoted by "0") and an output node, and the HIT flip-flop 208_j has a data input node, a clock input node and a data output node, where the first input node of the multiplexer 206_j acts as a scan input node of the scan flip-flop 204_j, the second input node of the multiplexer 206_j acts as a data input node of the scan flip-flop 204_j, the output node of the multiplexer 206_j is coupled to the data input node of the HIT flip-flop 208_j, and the data output node of the HIT flip-flop 208_j acts as a scan/data output node of the scan flip-flop 204_j. The multiplexer 206_j is controlled by control signals SE and DFTBYPASS. For example, a control input of the multiplexer 206_j is set by ORing SE and DFTBYPASS. The data input node of the scan flip-flop 204_j is configured to receive a functional data input from a functional path Func. In this embodiment, the data input node of the scan flip-flop 204_j is configured to receive a functional data input HIT[i+j] from a match line of the CAM (e.g., TCAM) 100. During a normal operation, the HIT flip-flop 208_j is used to buffer the HIT output HIT[i+j] and output the buffered HIT output HIT[i+j] to a following processing circuit such as a priority encoder (not shown).

It should be noted that the scan chain 202 starts from the scan flip-flop 204_0 and ends at the scan flip-flop 204_j. In other words, the scan flip-flop 204_0 is the first scan flip-flop of the scan chain 202, and the scan flip-flop 204_j is the last scan flip-flop of the scan chain 202. The number of scan flip-flop 204_j included in the same scan chain 202 may be adjusted depending on actual design considerations.

The multiplexer 201 has a first input node (denoted by "1"), a second input node (denoted by "0") and an output node, where the first input node of the multiplexer 201 is configured to receive a scan chain data input SIH[m] of the scan chain 200, the second input node of the multiplexer 201 is configured to receive a scan data output SOH[m] from the scan output node of the scan flip-flop 204_j (which is the last scan flip-flop of the scan chain 202), and the output node of the multiplexer 201 is configured to provide a multiplexer output SIH_MUX[m] (which is one of the scan chain data input SIH[m] and the scan data output SOH[m]) to the scan input node of the scan flip-flop 204_0 (which is the first scan flip-flop of the scan chain 202). The multiplexer 201 is controlled by the control signal SE (Scan Enable).

When the scan test circuit 200 is employed for testing HIT flip-flops of the bank BANK0 of the CAM (e.g., TCAM) 100 shown in FIG. 1, m=0, i=0, and j=127. When the scan test circuit 200 is employed for testing HIT flip-flops of the bank BANK1 of the CAM (e.g., TCAM) 100 shown in FIG. 1, m=1, i=128, and j=127. When the scan test circuit 200 is employed for testing HIT flip-flops of the bank BANK2 of the CAM (e.g., TCAM) 100 shown in FIG. 1, m=2, i=256, and j=127. When the scan test circuit 200 is employed for testing HIT flip-flops of the bank BANK3 of the CAM (e.g., TCAM) 100 shown in FIG. 1, m=3, i=384, and j=127. However, these are for illustrative purposes only, and are not meant to be limitations of the present invention.

The scan test circuit 200 supports three operation modes, including a Scan Shift mode, a Scan Capture mode, and a Functional mode. The operation modes are enabled by the control signals SE and DFTBYPASS, as illustrated in the following table.

**Table 1**

| Mode | SE | DFTBYPASS |
|---|---|---|
| Scan Shift | 1 | X (Don't Care) |
| Scan Capture | 0 | 1 |
| Functional | 0 | 0 |

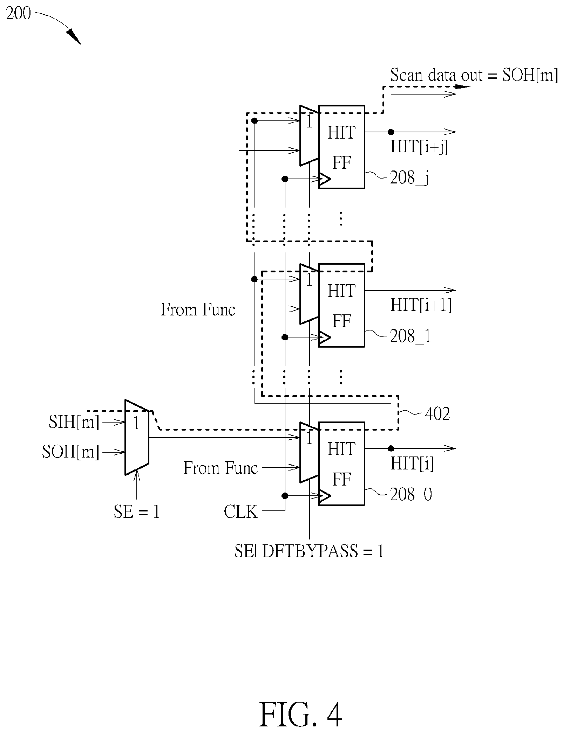

FIG. 4 is a diagram illustrating the scan test circuit 200 operating in the Scan Shift mode according to an embodiment of the present invention. The multiplexer 201 is controlled by SE=1 to couple its output node to its first input node, thus passing the scan chain data input SIH[m] to the first input node of the multiplexer 206_0 included in the scan flip-flop 204_0 (which is the first scan flip-flop of the scan chain 202). All multiplexers 206_0-206_j included in the scan flip-flops 204_0-204_j are controlled by the same control signal SE|DFTBYPASS=1, where SE=1 and DFTBYPASS=X. Hence, as illustrated by the data path 402 in FIG. 4, the scan chain data input SIH[m] shifts through HIT flip-flops 208_0-208_j (which act as shift registers) in (j+1) clock cycles of the clock CLK. The scan chain data input SIH[m] is set by a pre-defined bit pattern. In this way, bits stored in the HIT flip-flops 208_0-208_j are initialized by the pre-defined bit pattern used in the Scan Shift mode.

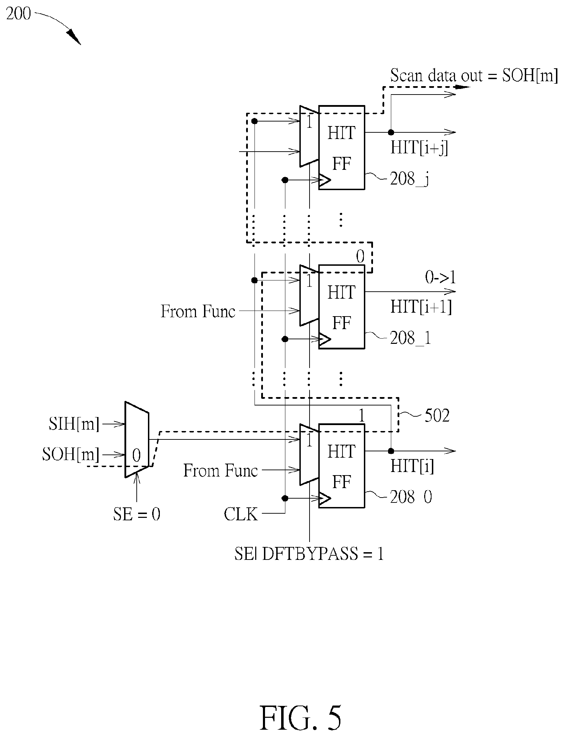

FIG. 5 is a diagram illustrating the scan test circuit 200 operating in the Scan Capture mode according to an embodiment of the present invention. The multiplexer 201 is controlled by SE=0 to couple its output node to its second input node, thus passing the scan data output SOH[m] of the scan flip-flop 204_j (which is the last scan flip-flop of the scan chain 202) to the first input node of the multiplexer 206_0 included in the scan flip-flop 204_0 (which is the first scan flip-flop of the scan chain 202). All multiplexers 206_0-206_j included in the scan flip-flops 204_0-204_j are controlled by the same control signal SE|DFTBYPASS=1, where SE=0 and DFTBYPASS=1. As illustrated by the data path 502 in FIG. 5, the Scan Capture mode operation of the scan chain 202 is similar to the Scan Shift mode operation of the scan chain 202, and the difference is that the HIT flip-flop 208_0 receives the scan data output SOH[m] in the Scan Capture mode. Since the scan data output SOH[m] shifts through HIT flip-flops 208_0-208_j, 0->1, 1->0 transition can be applied. For example, during the Scan Shift mode, a storage state of the HIT flip-flop 208_0 is initialized by bit '1', and a storage state of the HIT flip-flop 208_1 is initialized by bit '0'; and during the Scan Capture mode, bit '1' in the HIT flip-flop 208_0 shifts to the HIT flip-flop 208_1, resulting in 0->1 transition at the HIT flip-flop 208_1. With the aid of a proper setting of the pre-defined bit pattern of the scan chain data input SIH[m] used for initializing the HIT flip-flops 208_0-208_j in the Scan Shift mode, both of 0->1 transition and 1->0 transition can be tested on each HIT flip-flop during the Scan Capture mode.

In summary, the present invention proposes adding scan flip-flops (scan cells) for HIT outputs of a CAM (e.g., TCAM) as well as adding multiplexers to enable the Scan Shift mode and the Scan Capture mode of scan test circuits, which can improve the DFT coverage with minimum impact on power, performance, and area (PPA). For example, additional multiplexers added to the proposed scan test circuit can collaborate with existing HIT flip-flops to enable the Scan Capture (DFTBYPASS) mode operation with minimum impact on PPA.

## Claims

1. A scan test circuit (200, 302_0, 302_1, 302_3) **characterized by**:
a scan chain (202), comprising:
a plurality of scan flip-flops (204_0, 204_j), each having a data input node, a scan input node, and an output node, wherein the data input node is configured to receive a functional data input from a match line of a content addressable memory (100), hereinafter referred to as CAM.

2. The scan test circuit (200, 302_0, 302_1, 302_3) of claim 1, **characterized in that** the CAM (100) is a ternary content addressable memory.

3. The scan test circuit (200, 302_0, 302_1, 302_3) of claim 1, **characterized in that** the plurality of scan flip-flops (204_0, 204_j) comprise a first scan flip-flop (204_0) and a second scan flip-flop (204_j), the scan chain (202) starts from the first scan flip-flop (204_0) and ends at the second scan flip-flop (204_j), and the scan test circuit (200, 302_0, 302_1, 302_3) further comprises:
a first multiplexer (201), having a first input node, a second input node, and an output node, wherein the first input node of the first multiplexer (201) is configured to receive a scan chain data input (SIH[m]) of the scan chain (202), the second input node of the first multiplexer (201) is configured to receive a scan data output (SOH[m]) from the output node of the second scan flip-flop (204_j), and the output node of the first multiplexer (201) is configured to output one of the scan chain data input (SIH[m]) and the scan data output (SOH[m]) to the scan input node of the first scan flip-flop (204_0).

4. The scan test circuit (200, 302_0, 302_1, 302_3) of claim 3, **characterized in that** each of the plurality of scan flip-flops (204_0, 204_j) comprises:
a second multiplexer (206_0, 206_j), having a first input node, a second input node, and an output node, wherein the first input node of the second multiplexer (206_0, 206_j) acts as the scan input node, and the second input node of the second multiplexer (206_0, 206_j) acts as the data input node;
wherein when the scan test circuit (200, 302_0, 302_1, 302_3) operates in a scan shift mode, the output node of the first multiplexer (201) is coupled to the first input node of the first multiplexer (201), and the output node of the second multiplexer (206_0, 206_j) is coupled to the first input node of the second multiplexer (206_0, 206_j).

5. The scan test circuit (200, 302_0, 302_1, 302_3) of claim 3, **characterized in that** each of the plurality of scan flip-flops (204_0, 204_j) comprises:
a second multiplexer (206_0, 206_j), having a first input node, a second input node, and an output node, wherein the first input node of the second multiplexer (206_0, 206_j) acts as the scan input node, and the second input node of the second multiplexer (206_0, 206_j) acts as the data input node;
wherein when the scan test circuit (200, 302_0, 302_1, 302_3) operates in a scan capture mode, the output node of the first multiplexer (201) is coupled to the second input node of the first multiplexer (201), and the output node of the second multiplexer (206_0, 206_j) is coupled to the first input node of the second multiplexer (206_0, 206_j).

6. The scan test circuit (200, 302_0, 302_1, 302_3) of claim 1, **characterized in that** match lines of the CAM (100) are divided into a plurality of match line groups, and data input nodes of the plurality of scan flip-flops (204_0, 204_j) are coupled to match lines included in only one of the plurality of match line groups.

7. A scan test circuit (200, 302_0, 302_1, 302_3) **characterized by**:
a scan chain (202), comprising:
a plurality of scan flip-flops (204_0, 204_j), each having a data input node, a scan input node, and an output node, wherein the plurality of scan flip-flops (204_0, 204_j) comprise a first scan flip-flop (204_0) and a second scan flip-flop (204_j), and the scan chain (202) starts from the first scan flip-flop (204_0) and ends at the second scan flip-flop (204_j); and
a first multiplexer (201), having a first input node, a second input node, and an output node, wherein the first input node of the first multiplexer (201) is configured to receive a scan chain data input (SIH[m]) of the scan chain (202), the second input node of the first multiplexer (201) is configured to receive a scan data output (SOH[m]) from the output node of the second scan flip-flop (204_j), and the output node of the first multiplexer (201) is configured to output one of the scan chain data input (SIH[m]) and the scan data output (SOH[m]) to the scan input node of the first scan flip-flop (204_0).

8. The scan test circuit (200, 302_0, 302_1, 302_3) of 7, **characterized in that** the data input node is configured to receive a functional data input from a match line of a content addressable memory (100), hereinafter referred to as CAM.

9. The scan test circuit (200, 302_0, 302_1, 302_3) of claim 8, **characterized in that** the CAM (100) is a ternary content addressable memory.

10. The scan test circuit (200, 302_0, 302_1, 302_3) of claim 8, **characterized in that** match lines of the CAM (100) are divided into a plurality of match line groups, and data input nodes of the plurality of scan flip-flops (204_0, 204_j) are coupled to match lines included in only one of the plurality of match line groups.

11. The scan test circuit (200, 302_0, 302_1, 302_3) of claim 7, **characterized in that** each of the plurality of scan flip-flops (204_0, 204_j) comprises:
a second multiplexer (206_0, 206_j), having a first input node, a second input node, and an output node, wherein the first input node of the second multiplexer (206_0, 206_j) acts as the scan input node, and the second input node of the second multiplexer (206_0, 206_j) acts as the data input node;
wherein when the scan test circuit (200, 302_0, 302_1, 302_3) operates in a scan shift mode, the output node of the first multiplexer (201) is coupled to the first input node of the first multiplexer (201), and the output node of the second multiplexer (206_0, 206_j) is coupled to the first input node of the second multiplexer (206_0, 206_j).

12. The scan test circuit (200, 302_0, 302_1, 302_3) of claim 7, **characterized in that** each of the plurality of scan flip-flops (204_0, 204_j) comprises:
a second multiplexer (206_0, 206_j), having a first input node, a second input node, and an output node, wherein the first input node of the second multiplexer (206_0, 206_j) acts as the scan input node, and the second input node of the second multiplexer (206_0, 206_j) acts as the data input node;
wherein when the scan test circuit (200, 302_0, 302_1, 302_3) operates in a scan capture mode, the output node of the first multiplexer (201) is coupled to the second input node of the first multiplexer (201), and the output node of the second multiplexer (206_0, 206_j) is coupled to the first input node of the second multiplexer (206_0, 206_j).
